# EUROPEAN PATENT SPECIFICATION

(11) **EP 4 498 439 B1**
(45) Date of publication and mention of the grant of the patent: **22.10.2025**
(21) Application number: 24190356.6
(22) Date of filing: 23.07.2024
(51) Int. Cl.: H10H 20/811, H10H 20/825, H10H 20/812

(54) **LIGHT EMITTING ELEMENT AND DISPLAY DEVICE USING LIGHT EMITTING ELEMENT**
LICHTEMITTIERENDES ELEMENT UND ANZEIGEVORRICHTUNG MIT DEM LICHTEMITTIERENDEN ELEMENT
ÉLÉMENT ÉLECTROLUMINESCENT ET DISPOSITIF D'AFFICHAGE UTILISANT UN ÉLÉMENT ÉLECTROLUMINESCENT

(30) Priority: 26.07.2023 KR 20230097670; 01.12.2023 KR 20230172514
(43) Date of publication of application: 29.01.2025
(73) Proprietor: SAMSUNG ELECTRONICS CO., LTD., Yeongtong-gu Suwon-si, Gyeonggi-do 16677 (KR)
(72) Inventor: KIM, Jonghak, 16677 Suwon-si, Gyeonggi-do (KR); CHOI, Punjae, 16677 Suwon-si, Gyeonggi-do (KR); PARK, Sooyoung, 16677 Suwon-si, Gyeonggi-do (KR); INOUE, Shigeru, 16677 Suwon-si, Gyeonggi-do (KR)
(74) Representative: Kuhnen & Wacker Patent- und Rechtsanwaltsbüro PartG mbB

(56) References cited:
- WO-A1-2018/012585
- US-A1- 2012 049 155
- US-A1- 2013 193 409
- US-A1- 2022 310 884

## Description

### BACKGROUND

The present disclosure relates to a light emitting element and a display device using the same.

Recently, there has been demand for smaller light-emitting diodes (LEDs) applicable to display devices for mobile devices such as smartphones and augmented reality (AR)/virtual reality (VR) devices. When LEDs are applied to displays for mobile devices, low power consumption may be implemented through high luminous efficiency, resulting in increased battery use time. As high resolution is required, ultra-small LED elements (for example, having a width of 200 µm or less) may be required. In particular, for displays for AR/VR devices having a very small distance from the eyes, even ultra-small LED elements (for example, having a width of 20 µm or less) may be required.

An example of an ultra-thin LED element for a full-color light-emitting diode (LED) display is known from US 2022/0310884 A1.

### SUMMARY

One or more example embodiments provide an ultra-small light-emitting diode (LED) element having excellent reliability and high luminous efficiency.

One or more example embodiments provide a display device using an ultra-small LED element having excellent reliability and high luminous efficiency.

According to the invention, a light emitting stack including an active layer between an N-type nitride semiconductor layer and a P-type nitride semiconductor layer, the light emitting stack having a width of 5 nm or more and 200 µm or less; a first electrode connected to the N-type nitride semiconductor layer; and a second electrode connected to the P-type nitride semiconductor layer. The P-type nitride semiconductor layer has a first surface, adjacent to the active layer, and a second surface, opposite to the first surface, and includes AlₓIn_{y}Ga_{z}N (0≤x < 1, 0≤y < 1, 0 < z≤1) wherein a bandgap of the p-type nitride semiconductor layer does not increase in a stacking direction from the second surface to the first surface. The N-type nitride semiconductor layer includes a superlattice layer and an electron retardation layer.

According to an example embodiment according to the invention, a display device includes: a circuit board including a plurality of driving circuits; and a pixel array including a plurality of light emitting elements on the circuit board. A light emitting element of the plurality of light emitting elements includes: a light emitting stack including an active layer between an N-type nitride semiconductor layer and a P-type nitride semiconductor layer; a first electrode connected to the N-type nitride semiconductor layer; and a second electrode connected to the P-type nitride semiconductor layer. The plurality of light emitting elements are electrically connected to the plurality of driving circuits, respectively. The P-type nitride semiconductor layer has a first surface, adjacent to the active layer, and a second surface, opposite to the active layer, and includes AlₓIn_{y}Ga_{z}N(0≤x < 1, 0≤y < 1, 0 < z≤1) wherein a bandgap of the p-type nitride semiconductor layer does not increase in a stacking direction from the second surface to the first surface. The N-type nitride semiconductor layer includes a superlattice layer and an electron retardation layer.

For example, a pixel array includes: a substrate; and a plurality of light emitting elements on the substrate. A first light emitting elements, among the plurality of light emitting elements, may include: a light emitting stack including an active layer between an N-type nitride semiconductor layer and a P-type nitride semiconductor layer, the light emitting stack having a width of 5 nm or more and 200 µm or less; a first electrode connected to the N-type nitride semiconductor layer; and a second electrode connected to the P-type nitride semiconductor layer. The P-type nitride semiconductor layer may have a first surface, adjacent to the active layer, and a second surface, opposite to the first surface, and include AlₓIn_{y}Ga_{z}N (0≤x < 1, 0≤y < 1, 0 < z≤1), wherein a bandgap of the p-type nitride semiconductor layer does not increase in a stacking direction from the second surface to the first surface. The N-type nitride semiconductor layer includes a superlattice layer and an electron retardation layer.

### BRIEF DESCRIPTION OF DRAWINGS

The above and other aspects, features, and advantages will be more apparent from the following description of example embodiments, taken in conjunction with the accompanying drawings, in which:
FIG. 1A is a perspective view of a semiconductor light emitting element according to an example embodiment, and FIG. 1B is a side cross-sectional view of the semiconductor light emitting element illustrated in FIG. 1A, taken along line I-I';
FIG. 2 is a partially enlarged view of portion "A" of the semiconductor light emitting element illustrated in FIG. 1B, and illustrates a specific structure of an electron retardation layer according to an example embodiment;
FIGS. 3A to 3F are graphs illustrating a change in band gap in a stacking direction in various P-type nitride semiconductor layers applicable to the semiconductor light emitting element illustrated in FIG. 1B;
FIGS. 4A to 4F are graphs illustrating Al content distributions in a stacking direction in various P-type nitride semiconductor layers applicable to the semiconductor light emitting element illustrated in FIG. 1B;
FIGS. 5A to 5F are graphs illustrating Al content distributions and In content distributions in a stacking direction in various P-type nitride semiconductor layers applicable to the semiconductor light emitting element illustrated in FIG. 1B;
FIGS. 6A and 6B are perspective views of semiconductor light emitting elements according to various example embodiments;
FIG. 7 is a side cross-sectional view of a semiconductor light emitting element according to an example embodiment;
FIG. 8 is a schematic perspective view of a display device according to an example embodiment;
FIG. 9 is a partially enlarged view of portion "B" of the display device illustrated in FIG. 7;
FIG. 10 is a side cross-sectional view of a display device according to an example embodiment;
FIG. 11 is a driving circuit implemented by a display device according to an example embodiment;
FIG. 12 is a side cross-sectional view of a display device according to an example embodiment; and
FIG. 13 is a schematic diagram illustrating an electronic device including a display device according to an example embodiment.

### DETAILED DESCRIPTION

Hereinafter, example embodiments will now be described more fully with reference to the accompanying drawings. Embodiments described herein are provided as examples, and thus, the present disclosure is not limited thereto, and may be realized in various other forms. Each embodiment provided in the following description is not excluded from being associated with one or more features of another example or another embodiment also provided herein or not provided herein but consistent with the present disclosure. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Components indicated in various example embodiments may be partially substituted or combined. In example embodiments described below, descriptions of common features with those described above will be omitted, and only differences will be described. The sizes of components, illustrated in each drawing, and positional relationships between the components may be exaggerated for effective description.

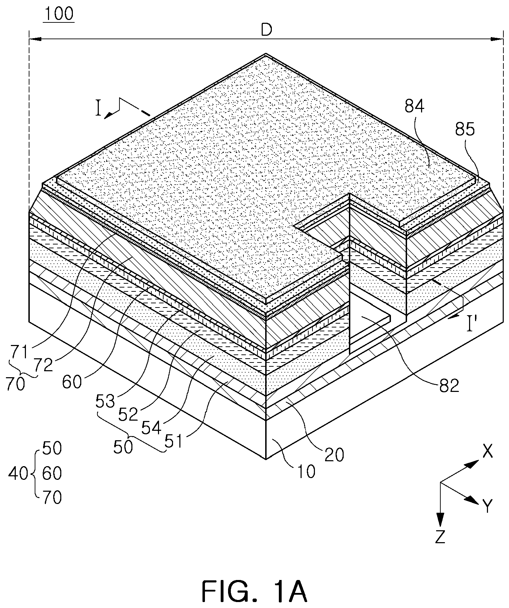

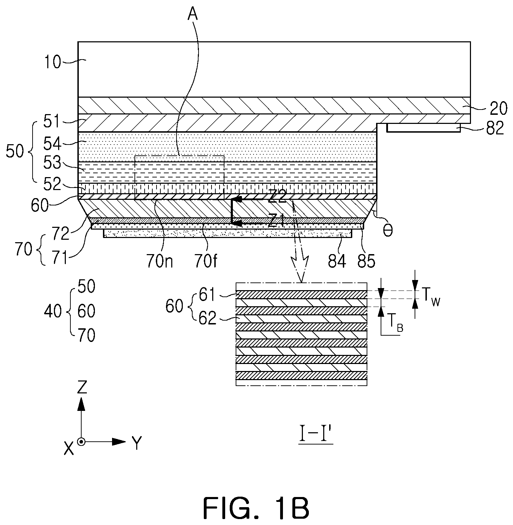

FIG. 1A is a perspective view of a semiconductor light emitting element according to an example embodiment, and FIG. 1B is a side cross-sectional view of the semiconductor light emitting element illustrated in FIG. 1A, taken along line I-I';

Referring to FIGS. 1A and 1B, a semiconductor light emitting element 100 according to an example embodiment includes a light emitting stack 40 including an N-type nitride semiconductor layer 50, an active layer 60, and a P-type nitride semiconductor layer 70, sequentially stacked, a first electrode 82 electrically connected to the N-type nitride semiconductor layer 50, and a second electrode 84 electrically connected to the P-type nitride semiconductor layer 70. Unless otherwise described, a size D of the semiconductor light emitting element 100 is used to indicate a width of the light emitting stack 40. For example, the size D of the light emitting stack 40 may be defined as a maximum width of the active layer 60, as illustrated in FIG. 1A.

In accordance with the claimed invention, the size D of the semiconductor light emitting element 100 is 200 µm or less. In some example embodiments for application to display devices, such as those used in augmented reality (AR) and virtual reality (VR), the size D of the semiconductor light emitting element 100 may be 20 µm or less. According to the claimed invention, the size D of the light emitting element 100 is greater than 5 nm.

The P-type nitride semiconductor layer 70 has a first surface 70n, adjacent to the active layer 60, and a second surface 70f, opposite to that of the first surface, and may have an Al content not decreasing when a distance from the active layer 60 from the first surface 70n to the second surface 70f increases. The P-type nitride semiconductor layer 70 may include Al. In an example embodiment, the Al content of the P-type nitride semiconductor layer 70 may increase as a distance from the active layer 60 increases.

The P-type nitride semiconductor layer 70 according to an example embodiment may have an inclined side surface. For example, the side surface may be oblique with respect to each of the first surface 70n and the second surface 70f. The P-type nitride semiconductor layer 70 may have a second width on the second surface, narrower than a first width on the first surface. In addition, the side surface of the P-type nitride semiconductor layer 70 may not be planar. As illustrated in FIG. 1B, an inclination angle θ of the side surface of the P-type nitride semiconductor layer 70 may be defined as an angle between a vertical line and a line, connecting a side end of the first surface 70n to a side end of the second surface 70f. For example, the inclination angle θ of the side surface of the P-type nitride semiconductor layer 70 may be 3 degrees or more and 45 degrees or less. In the case of a micro-semiconductor light emitting element 100, the N-type nitride semiconductor layer 50 may have a vertical side surface without an inclination, as illustrated, but example embodiments are not limited thereto. In some example embodiments, the N-type nitride semiconductor layer 50 may have an inclined side surface, and the P-type nitride semiconductor layer 70 may have a side surface having a larger inclination angle.

In the related art, an electron blocking layer may be provided to suppress electron overflow (electrons passing through an active layer without recombining and move to a P-type nitride semiconductor layer), but may also serve to delay the progression of holes toward the active layer 60. Due to such delay, the number of holes moving to a defective region on the side surface of the P-type nitride semiconductor layer 70 may increase, and the number of holes lost due to non-radiative combination in the defective region may also increase. In particular, in the micro-semiconductor light emitting element, a ratio of the number of lost holes to the number of radiatively recombined holes may tend to be higher, which may be a major cause of a decrease in luminous efficiency. According to one or more example embodiments, in the P-type nitride semiconductor layer 70, the electron blocking layer EBL may be omitted.

In an example embodiment, the movement of holes to the active layer 60 may be smoothed by an etching operation, such as a plasma etching operation. By providing a smooth surface of the active layer 60, the holes injected into a damaged region of the side surface of the P-type nitride semiconductor layer 70 may be reduced, thereby reducing the number of holes lost. In addition, the P-type nitride semiconductor layer 70, in particular, a region from the second surface 70f into which holes are injected, may include Al, thereby a portion of the damaged region of the side surface of the P-type nitride semiconductor layer 70 may be etched and removed in a subsequent process.

The light emitting stack 40 may be formed by performing deposition on a growth substrate 10, using a method such as metal organic chemical vapor deposition (MOCVD). The light emitting stack 40 may be formed of a nitride semiconductor including Ga. The growth substrate 10 may be formed of a material different from that of the light emitting stack 40, for example, sapphire, SiC, or Si, may be used. In this case, a buffer stack 20 may be formed on the growth substrate 10, and then the light emitting stack 40 may be formed on the buffer stack 20. In some example embodiments, the growth substrate 10 may include a material the same as that of the light emitting stack 40, such as GaN.

The growth substrate 10 and the buffer stack 20 may be partially or entirely removed during a process of manufacturing the light emitting element 100. Accordingly, the light emitting element 100 may further include the growth substrate 10, and may further include the buffer stack 20 between the growth substrate 10 and the light emitting stack 40. In some example embodiments, the semiconductor light emitting element 100 may include only a portion of the buffer stack 20 without the growth substrate 10. In this regard, the growth substrate 10 may be completely removed and the buffer stack 20 may be partially removed.

The P-type nitride semiconductor layer 70 according to an example embodiment may be a nitride semiconductor layer including P-type impurities such as Mg or the like. The P-type nitride semiconductor layer 70 may include a P-type highly doped layer 71 and a P-type normally doped layer 72, which may correspond to a remaining region of the P-type nitride semiconductor layer 70 (other than the P-type highly doped layer 71).

The P-type highly doped layer 71 may provide the second surface 70f of the P-type nitride semiconductor layer 70. The P-type highly doped layer 71 may have a P-type impurity content, higher than that of the remaining portion of the P-type nitride semiconductor layer 70. For example, a concentration of P-type impurities in the P-type highly doped layer 71 may be 1×10¹⁸/cm³ to 1×10²²/cm³. The second electrode 84 may be in direct contact with the P-type highly doped layer 71, or may be connected to the P-type highly doped layer 71 through a P-type contact electrode 85, formed of a transparent conductive material such as ITO. In some example embodiments, the P-type contact electrode 85 may cover the entire second surface 70f.

In some example embodiments, the P-type nitride semiconductor layer 70 may include, for example, an undoped semiconductor layer. The undoped semiconductor layer may refer to a layer grown without adding impurities during growth, and may include, for example, unavoidable impurities incorporated by diffusion from adjacent layers. In some example embodiments, the P-type nitride semiconductor layer 70 may locally include N-type impurities, for example.

The active layer 60 may have a multi-quantum well structure including a plurality of barrier layers 62 and a plurality of well layers 61, respectively positioned between the plurality of barrier layers 62. The light emitting element 100 according to an example embodiment may be a light emitting element 100, which emits blue light in the active layer 60. The light emitting element 100 may include a well layer 61 formed of a nitride semiconductor including In and Ga. The barrier layer 62 may be a nitride semiconductor layer including Ga. A bandgap energy of the barrier layer 62 may be greater than a bandgap energy of the well layer 61. A film thickness T_{B} of the barrier layer 62 may be, for example, 1 nm or more and 35 nm or less. A film thickness T_{W} of the well layer 61 may be, for example, 1 nm or more and 30 nm or less. In some example embodiments, a film thickness of each of some well layers, among the plurality of well layers 61, may be different from a film thickness of each of other well layers.

The N-type nitride semiconductor layer 50 according to the invention includes a superlattice layer 52, an electron retardation layer 53, and an N-type GaN layer 54.

The N-type nitride semiconductor layer 50 may include N-type impurities, and may include an N-type GaN layer 54. The N-type impurities may be, for example, N-type impurities such as Si. In some example embodiments, in similar manner to the P-type nitride semiconductor layer 70 described above, the N-type nitride semiconductor layer 50 may include a portion of an undoped semiconductor layer.

The N-type nitride semiconductor layer 50 according to an example embodiment may further include an N-type highly doped layer 51 having an impurity concentration, higher than that of a remaining region of the N-type nitride semiconductor layer 50 including the superlattice layer 52, the electron retardation layer 53, and the N-type GaN layer 54. For example, a concentration of N-type impurities in the N-type highly doped layer 51 may be 1×10¹⁶/cm³ or more and 1×10²²/cm³ or less. The N-type highly doped layer 51 may be positioned to be farther from the active layer 60 than the superlattice layer 52 and the electron retardation layer 53. The N-type highly doped layer 51 may be disposed to be closer to the first electrode 82 than to the active layer 60. In an example embodiment, the N-type highly doped layer 51 may be provided to be in contact with the first electrode 82. In some example embodiments, the N-type nitride semiconductor layer 50 may further include an additional contact layer between the first electrode 82 and the N-type highly doped layer 51.

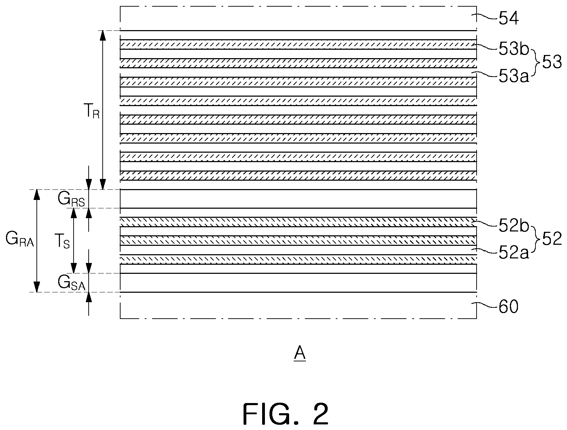

Hereinafter, a structure and operation of the superlattice layer 52 and the electron retardation layer 53 according to example embodiments will be described in detail with reference to FIG. 2. FIG. 2 is a partially enlarged view of the electron retardation layer 53 applied to the light emitting element illustrated in FIG. 1B.

Referring to FIG. 2, a distance G_{SA} between the superlattice layer 52 and the active layer 60 may be 0.5 nm to 1000 nm. The superlattice layer 52 may have a multilayer structure in which a pair of a first sublayer 52a including In and a second sublayer 52b having a composition, different from that of the first sublayer 52a, is repeated two or more times.

The first sublayers 52a and the second sublayers 52b may be represented by the general formulas Alₓ₁In_{y1}Ga_{z1}N(0≤x1 < 1, 0 < y1 < 1, 0 < z1 < 1) and Alₓ₂In_{y2}Ga_{z2}N (0≤x2 < 1, 0≤y2 < 1, 0 < z2≤1), respectively. Each of the first sublayers 52a and the second sublayers 52b may have a thickness of 0.1 nm or more and 100 nm or less. Each of the first sublayers 52a and the second sublayers 52b may have a uniform thickness. However, some of the first sublayers 52a may have a thickness different from that of other ones of the first sublayers 52a, and/or some of the second sublayers 52b may have a thickness different from that of other ones of the second sublayers 52b. Referring to FIG. 2, a distance G_{RA} between the electron retardation layer 53 and the active layer 60 may be 0.5 nm to 1000 nm. A thickness TR of the electron retardation layer 53 may be 2 nm to 1000 nm, preferably 50 nm to 500 nm.

The electron retardation layer 53 may have an adjusted bandgap or conductivity. When the band gap is further increased, electrons may be diffused in front of an energy barrier of the electron retardation layer 53. When the band gap is decreased, electrons may be diffused in a well of the electron retardation layer 53. When the conductivity is increased, electrons may be diffused in a high-conductivity layer of the electron retardation layer 53, and may be allowed to remain in the high-conductivity layer and then to move, thereby retarding the movement of the electrons. In some example embodiments, the electron retardation layer 53 may be a layer having a band gap, different from that of the N-type GaN layer 54, or a layer in which a highly doped layer and a lightly doped layer are repeated one or more times.

In an example embodiment, the superlattice layer 52 may be positioned between the electron retardation layer 53 and the active layer 60. In some example embodiments, the electron retardation layer 53 may be disposed between the superlattice layer 52 and the active layer 60. For example, a distance G_{RS} between the superlattice layer 52 and the electron retardation layer 53 may be 0.5 nm to 1000 nm.

The electron retardation layer 53 may have a band gap, adjusted by changing a material composition. For example, the band gap of the electron retardation layer 53 may be increased by increasing an Al content, or may be decreased by increasing an In content.

In some example embodiments, the electron retardation layer 53 may be formed of a nitride semiconductor including Al and Ga. The bandgap of the electron retardation layer 53 may be greater than that of GaN. The electron retardation layer 53 may act as a barrier to electrons to delay electrons from being injected into the active layer 60, thereby reducing electron overflow. A compositional formula of the electron retardation layer 53 may be Alₓ₂In_{y2}Ga_{z2}N (0 < x2 < 1, 0≤y2 < 1, 0 < z2 < 1). An Al composition ratio (x2) may be preferably 0.5 or less. An Al content in the electron retardation layer 53 may have a constant value, but may increase or decrease depending on a thickness direction.

In some example embodiments, the electron retardation layer 53 may be formed of a nitride semiconductor containing In and Ga. The band gap of the electron retardation layer 53 may be less than that of GaN. Electrons, injected into the active layer 60, may be delayed in the electron retardation layer 53, thereby reducing electron overflow. A compositional formula of the electron retardation layer 53 may be Alₓ₂In_{y2}Ga_{z2}N (0≤x2 < 1, 0 < y2 < 1, 0 < z2 < 1). An In composition ratio (y2) may be preferably 0.3 or less. In a similar manner to Al described above, an In content in the electron retardation layer 53 may have a constant value, but may increase or decrease depending on a thickness direction. In some example embodiments, the In composition ratio (y2) may increase and then decrease.

In some example embodiments, the electron retardation layer 53 may include a first sublayer 53a and a second sublayer 53b, which may include materials having different compositions. Each of the first sublayer 53a and the second sublayer 53b may have a thickness of 0.1 nm to 1000 nm, and more preferably 1 nm to 100 nm.

The first sublayer 53a of the electron retardation layer 53 may be formed of a nitride semiconductor including Al and Ga. The bandgap of the electron retardation layer 53 may be greater than that of GaN. Compositional formulas of the first sublayer 53a and the second sublayer 53b may be Alₓ₃In_{y3}Ga_{z3}N (0 < x3 < 1, 0≤y3 < 1, 0 < z3 < 1) and Alₓ₄In_{y4}Ga_{z4}N (0≤x4 < 1, 0≤y4 < 1, 0 < z4≤1), respectively. Al composition ratios (x3 and x4) may be preferably 0.5 or less.

The first sublayer 53a of the electron retardation layer 53 may be formed of a nitride semiconductor including In and Ga. The band gap of the electron retardation layer 53 may be less than that of GaN. Compositional formulas of the first sublayer 53a and the second sublayer 53b may be Alₓ₃In_{y3}Ga_{z3}N (0 < x3 < 1, 0≤y3 < 1, 0 < z3 < 1) and Alₓ₄In_{y4}Ga_{z4}N (0≤x4 < 1, 0≤y4 < 1, 0 < z4≤1), respectively. In composition ratios (y3 and y4) may be preferably 0.3 or less.

The electron retardation layer 53 may be a layer having conductivity, higher than that of other surrounding layers. To effectively increase conductivity, the electron retardation layer 53 may include a delta-doped layer. The delta-doped layer may be a layer having a locally increased doping concentration, and the electron retardation layer 53 may have a multilayer structure in which the delta-doped layer is repeated two or more times. In this case, a material in the electron retardation layer 53 may have a constant composition. The electron retardation layer 53 may be formed of GaN.

As described above, the electron retardation layer 53 may be added to the N-type nitride semiconductor layer 50, thereby increasing the probability of recombination of electrons and holes in the active layer 60.

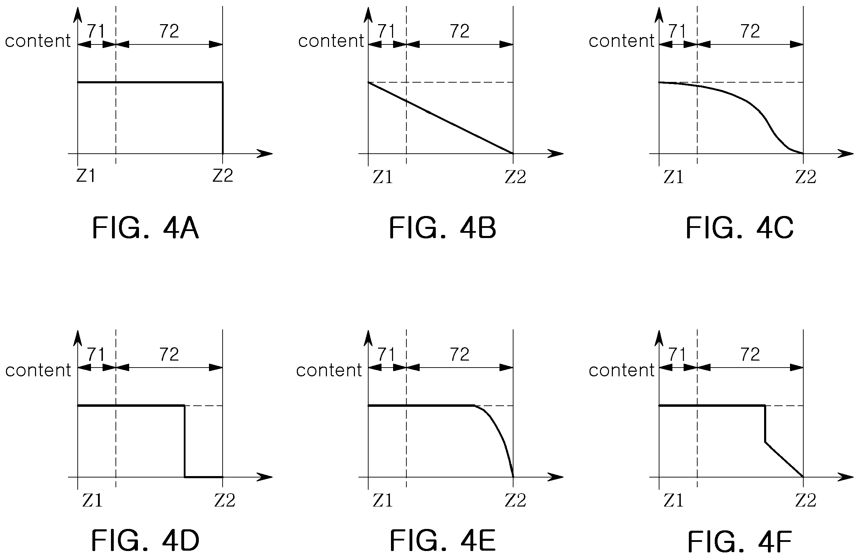

As described above, the P-type nitride semiconductor layer 70 according to an example embodiment may include a P-type highly doped layer 71 and a P-type normally doped layer 72. The P-type highly doped layer 71 and the P-type normally doped layer 72 may each include a nitride semiconductor containing Al. The P-type nitride semiconductor layer 70 may have various Al content distributions in a stacking direction, as illustrated in FIGS. 4A to 4F.

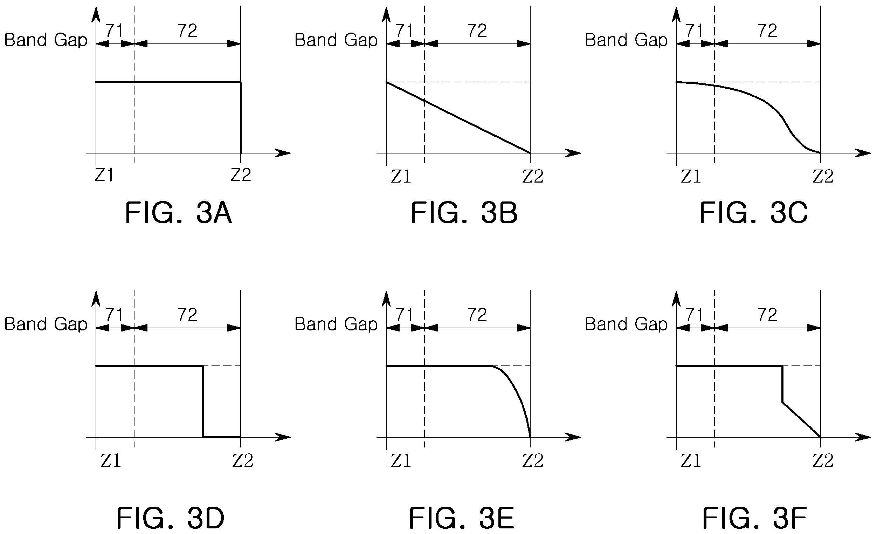

FIGS. 3A to 3F are graphs illustrating a change in band gap in a stacking direction in various P-type nitride semiconductor layers 70 applicable to the semiconductor light emitting element 100 in FIG. 1. Here, a horizontal axis represents a position in a Z-axis direction, and a vertical axis represents a band gap. A change in bandgap from the second surface 70f to the first surface 70n of the P-type nitride semiconductor layer 70 is illustrated.

Referring to FIGS. 3A to 3F, in common, a band gap in the P-type nitride semiconductor layer 70 may have various distributions, as long as, in accordance with the claimed invention, the band gap does not increase from the second surface 70f to the first surface 70n.

Referring to FIG. 3A, a bandgap in the P-type nitride semiconductor layer 70 according to an example embodiment may have a constant value. Referring to FIGS. 3B and 3C, a bandgap may linearly or gradually decrease over almost the entire region of the P-type nitride semiconductor layer 70. Referring to FIG. 3D, the P-type nitride semiconductor layer 70 may have a first region having a constant band gap, and a second region having a constant band gap less than that of the first region. In addition, referring to FIGS. 3E and 3F, a bandgap may have a relatively constant value in some regions from the second surface 70f of the P-type nitride semiconductor layer 70, and may have a decreasing distribution in other regions. A minimum bandgap in the P-type nitride semiconductor layer 70 or a bandgap at Z2 may be greater than or equal to a bandgap of GaN.

As such, a band gap in the P-type nitride semiconductor layer 70 may have various distributions under the condition that the band gap does not increase from the second surface 70f to the first surface 70n. When holes are injected from the second electrode 84 during operation of the semiconductor light emitting element 100, the movement of holes may not be hindered. The number of holes, moving to a defective region of a side surface (or an edge portion) of the P-type nitride semiconductor layer 70, may be reduced, and luminous efficiency may be increased. In the case that other conditions are the same, when the band gap decreases in a stepwise manner (for example, FIGS. 3A, 3D, and 3F), an electron blocking effect may be further increased to further improve luminous efficiency.

FIGS. 4A to 4F are graphs illustrating an Al content in a stacking direction (a Z-axis direction) in various P-type nitride semiconductor layers 70 applicable to the semiconductor light emitting element 100 in FIG. 1. Here, a horizontal axis represents a position in the Z-axis direction, and a vertical axis represents the Al content. An Al content from the second surface 70f to the first surface 70n of the P-type nitride semiconductor layer 70 is illustrated.

Referring to FIGS. 4A to 4F, in common, an Al content in the P-type nitride semiconductor layer 70 may not increase from the second surface 70f to the first surface 70n. In this case, an energy band gap may increase or decrease depending on the Al content, such that, in accordance with the invention as claimed, the energy band gap may not increase from the second surface 70f to the first surface 70n. An In content is not illustrated, but an In content in the P-type nitride semiconductor layer 70 may be lower than the Al content, may be substantially constant, and may not include In.

Referring to FIG. 4A, an Al content in the P-type nitride semiconductor layer 70 according to an example embodiment may be constant. Referring to FIGS. 4B and 4C, an Al content may linearly or gradually decrease over almost the entire region of the P-type nitride semiconductor layer 70. Referring to FIG. 4D, the P-type nitride semiconductor layer 70 may have a first region having a constant Al content, and a second region having a constant Al content lower than that of the first region. In addition, referring to FIGS. 4E and 4F, an Al content may be relatively constant in some regions from the second surface 70f of the P-type nitride semiconductor layer 70, and may have a decreasing distribution in other regions. When In is not included or a uniform In content is included, the P-type nitride semiconductor layer 70, having the content distributions illustrated in FIGS. 4A to 4F, may have the bandgap distributions illustrated in FIGS. 3A to 3F, respectively.

As such, an Al content in the P-type nitride semiconductor layer 70 may have various distributions under the condition that the Al content does not increase from the second surface 70f to the first surface 70n. When represented by the general formula AlₓIn_{y}Ga_{1-x-y}N, the Al content may be denoted by a value of x. In the graphs of FIGS. 4A to 4E, a maximum A1 content in the P-type nitride semiconductor layer 70 may be 0.01 to 0.5, more preferably 0.05 to 0.5. A minimum Al content in the P-type nitride semiconductor layer 70 may be greater than or equal to 0 and less than or equal to the maximum Al content. In the case that other conditions are the same, when the Al content decreases in a stepwise manner (for example, FIGS. 4A, 4D, and 4F), an electron blocking effect may be further increased to further improve luminous efficiency.

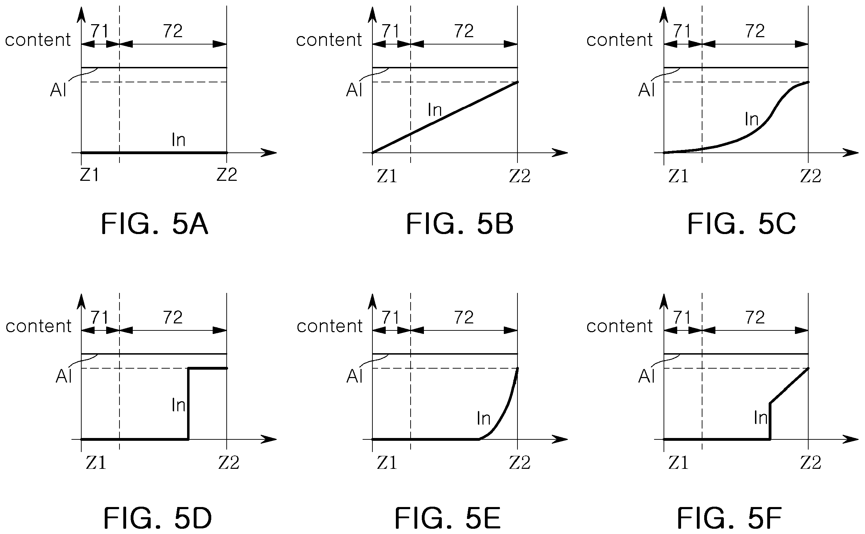

FIGS. 5A to 5F are graphs illustrating an Al content and an In content in a stacking direction (a Z-axis direction) in various P-type nitride semiconductor layers 70 applicable to the semiconductor light emitting element 100 in FIG. 1. Here, a horizontal axis represents a position in the Z-axis direction, and a vertical axis represents the Al content and the In content. An Al content and an In content from the second surface 70f to the first surface 70n of the P-type nitride semiconductor layer 70 are illustrated.

Referring to FIGS. 5A to 5F, in common, an In content in the P-type nitride semiconductor layer 70 may not decrease from the second surface 70f to the first surface 70n. In this case, an energy band gap may increase or decrease inversely with the In content, such that the energy band gap may not increase from the second surface 70f to the first surface 70n. The P-type nitride semiconductor layer 70 may necessarily include Al. An Al content in the P-type nitride semiconductor layer 70 may be higher than the In content, and may be constant.

Referring to FIG. 5A, an In content in the P-type nitride semiconductor layer 70 according to an example embodiment may be constant. Referring to FIGS. 5B and 5C, an In content may linearly or gradually increase over almost the entire region of the P-type nitride semiconductor layer 70. Referring to FIG. 5D, the P-type nitride semiconductor layer 70 may have a first region having a constant In content, and a second region having a constant In content higher than that of the first region. In addition, referring to FIGS. 5E and 5F, an In content may have a relatively constant in some regions from the second surface 70f of the P-type nitride semiconductor layer 70, and may have an increasing distribution in other regions. The P-type nitride semiconductor layer 70, having the content distributions illustrated in FIGS. 5A to 5F, may have the bandgap distributions illustrated in FIGS. 3A to 3F, respectively.

As such, an In content in the P-type nitride semiconductor layer 70 may have various distributions under the condition that the In content does not decrease from the second surface 70f to the first surface 70n. When represented by the general formula AlₓIn_{y}Ga_{1-x-y}N, the In content is denoted by a value of y. In the case that other conditions are the same, when the In content increases in a stepwise manner (for example, FIGS. 5A, 5D, and 5F), an electron blocking effect may be further increased to further improve luminous efficiency.

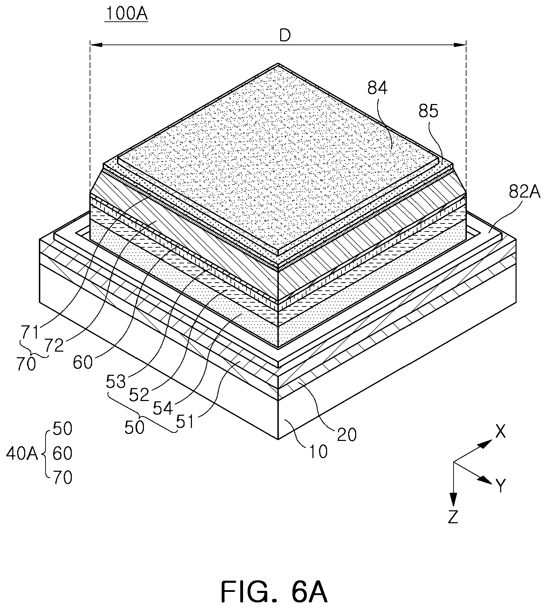

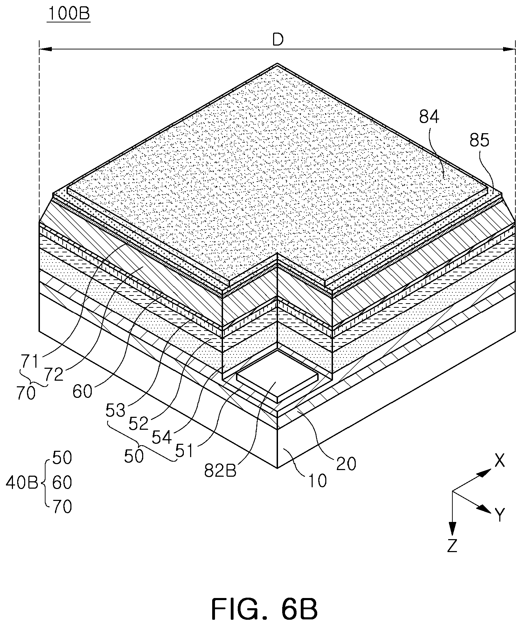

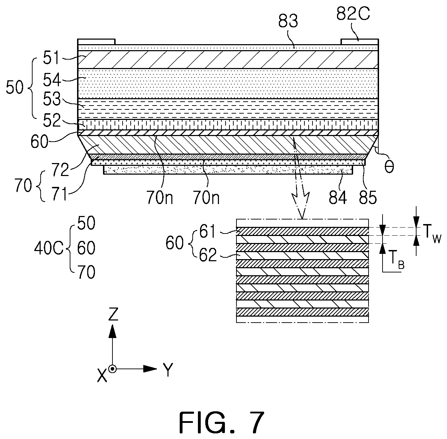

The light emitting element according to an example embodiment may have various structures. For example, depending on the arrangement of electrodes, the light emitting element may have various structures. FIGS. 6A and 6B are perspective views of semiconductor light emitting elements according to various example embodiments. FIG. 7 is a side cross-sectional view of a semiconductor light emitting element according to an example embodiment.

Referring to FIG. 6A, a semiconductor light emitting element 100A according to an example embodiment, similar the description above, may include a light emitting stack 40A including an N-type nitride semiconductor layer 50, an active layer 60, and a P-type nitride semiconductor layer 70, sequentially stacked, a first electrode 82A electrically connected to the N-type nitride semiconductor layer 50, and a second electrode 84 electrically connected to the P-type nitride semiconductor layer 70.

In contrast to the description above, the first electrode 82A according to an example embodiment may be formed to surround a portion of the light emitting stack 40A, that is, the active layer 60 and the P-type nitride semiconductor layer 70. The semiconductor light emitting element 100A may achieve relatively uniform light emission in the entire region of the light emitting stack 40A.

Referring to FIG. 6B, a semiconductor light emitting element 100B according to an example embodiment, in a similar manner to the description above, may include a light emitting stack 40B including an N-type nitride semiconductor layer 50, an active layer 60, and a P-type nitride semiconductor layer 70, sequentially stacked, a first electrode 82B electrically connected to the N-type nitride semiconductor layer 50, and a second electrode 84 electrically connected to the P-type nitride semiconductor layer 70.

In contrast to the description above, the first electrode 82B according to an example embodiment may be disposed on the N-type nitride semiconductor layer 50 exposed at one corner of the light emitting stack 40A.

Referring to FIG. 7, a semiconductor light emitting element 100C according to an example embodiment may include a first electrode 82C and a second electrode 84 disposed on both opposing surfaces of a light emitting stack 40C, the first electrode 82C and the second electrode 84 overlapping each other in a Z-axis direction. In contrast to the description above, in the semiconductor light emitting element 100C according to an example embodiment, the substrate 10 may be omitted, and an N-type nitride semiconductor layer 50 (in particular, an N-type highly doped layer 51) may be exposed. The exposed surface of the N-type nitride semiconductor layer 50 may be connected to the first electrode 82C.

In the arrangement of electrodes according to an example embodiment, current may flow through the semiconductor light emitting element 100C in a vertical direction, thereby achieving more uniform light emission in the entire region of the light emitting stack 40A.

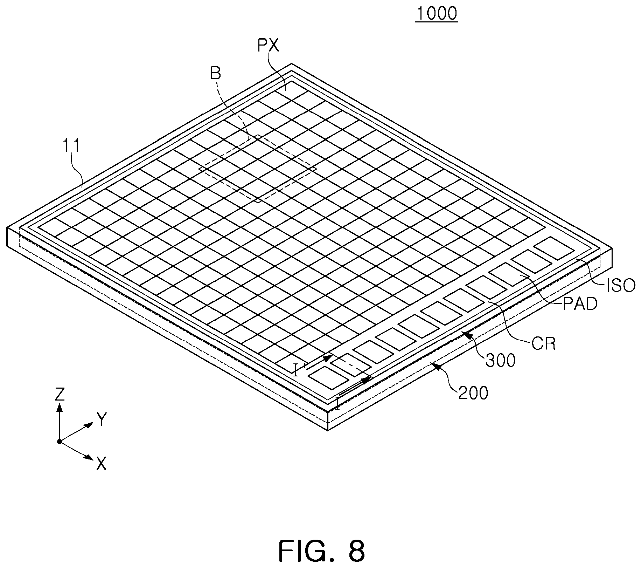

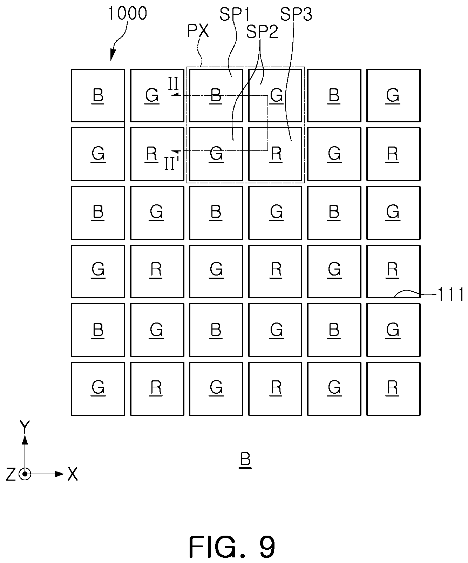

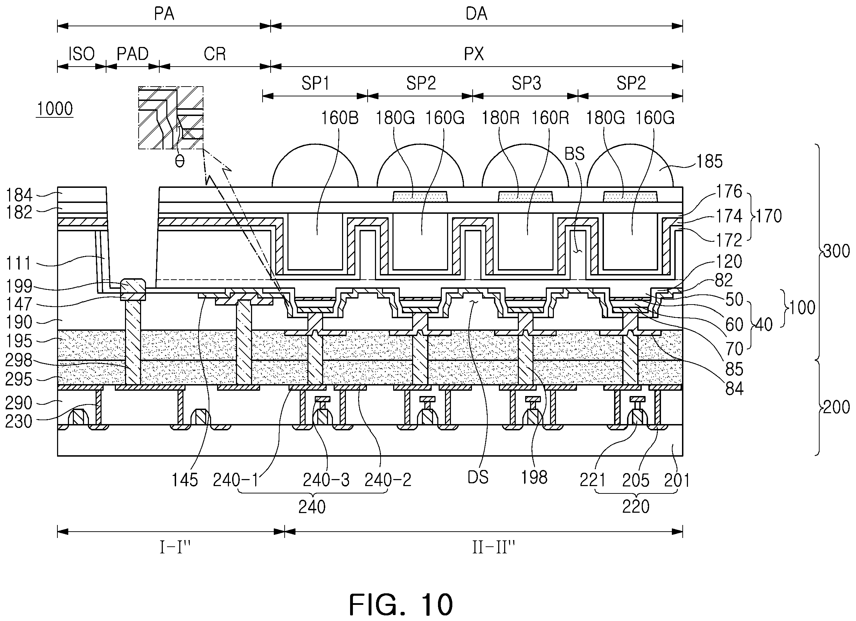

The light emitting elements 100, 100A, 100B, and 100C according to example embodiments may also be used as light sources for a display device. FIG. 8 is a schematic perspective view of a display device according to an example embodiment. FIG. 9 is a partially enlarged view of portion "B" of the display device illustrated in FIG. 7. FIG. 10 is a side cross-sectional view of a display device according to an example embodiment.

Referring to FIGS. 8 to 10, a display device 1000 according to an example embodiment may include a circuit board 200 including driving circuits, and a pixel array 300 disposed on the circuit board 200, the pixel array 300 including a plurality of pixels PX arranged thereon. The display device 1000 may further include a frame 11, surrounding the circuit board 200 and the pixel array 300.

The circuit board 200 may be a driving circuit board including driving elements (i.e., circuits) 220. In other example embodiments, the circuit board 200 may include only some of the driving circuits for the display device. In this case, the display device 1000 may further include another driving device. In some example embodiments, the display device 1000 may be a flexible or curved display device, and the circuit board 200 may include a flexible board.

In addition to the plurality of pixels PX, the pixel array 300 may further include connection pads PAD, a connection region CR connecting the plurality of pixels PX and the connection pads PAD to each other, and an edge region ISO.

Each of the plurality of pixels PX may include first to third subpixels SP1, SP2, and SP3 configured to emit light having a specific wavelength, for example, light having a specific color, in order to provide a color image. For example, the first to third subpixels SP1, SP2, and SP3 may be configured to emit blue (B) light, green (G) light, and red (R) light, respectively. In each pixel PX, the first to third subpixels SP1, SP2, and SP3 may be arranged in, for example, a Bayer pattern. Specifically, each pixel PX may include first and third subpixels SP1 and SP3 arranged in a first diagonal direction and two second subpixels SP2 arranged in a second diagonal direction, intersecting the first diagonal direction.

An X-direction and a Y-direction may be directions, perpendicular to each other and parallel to an upper surface of the display device 1000. A Z-direction may be a direction, perpendicular to the X-direction and the Y-direction, that is, a direction perpendicular to the upper surface of the display device 1000.

In FIG. 9, it is illustrated that each pixel PX includes the first to third subpixels SP1, SP2, and SP3 arranged in a 2×2 Bayer pattern, but example embodiments are not limited thereto. In another example embodiment, each pixel PX may be configured in a different array such as 3×3 or 4×4. In addition, in some example embodiments, some subpixels may be configured to emit light having a color different from the illustrated colors (R, G, and B), such as yellow light. In the pixel array 300 of FIG. 7, it is illustrated that the plurality of pixels PX are configured in an array of 15×15 having a small number of pixels for ease of description. However, depending on an actual application product, a column and a row may increase in size. For example, in order to apply the plurality of pixels PX to a high-resolution display, the plurality of pixels PX may need to be implemented in an array such as 1,920×1,080 (FHD), 3,840×2,160 (UHD), or the like. A smartwatch may have an array of about 400×400. A pixel size and a unit LED element size may vary depending on a size of the display device. For example, assuming a display device for a tablet, a display device for a smartphone, and a display device for a VR device having vertical sizes of 152.4 mm, 50.8 mm, and 38.1 mm, various pixel densities ranging from 180 ppi to 1,440 ppi may be required. A light emitting element having sufficient luminous efficiency may be required. For such applications, example embodiments provide a light emitting element 100 having improved luminous efficiency and a size of 200 µm or less. The light emitting element 100 may more preferably have a size D of 20 µm or less. The size D of the light emitting element 100 may be 5 nm or more. In addition, a distance between adjacent light emitting elements 100, disposed in the display device 1000 may be 5 nm to 100 µm.

Connection pads PAD may be disposed on at least one side of the plurality of pixels PX along an edge of the display device 1000. The connection pads PAD may be electrically connected to the plurality of pixels PX and the driving circuits of the circuit board 200. The connection pads PAD may electrically connect an external device and the display device 1000 to each other. In some example embodiments, the number of connection pads PAD may be changed in various manners, and may be determined, for example, depending on the number of pixels PX, a method in which the driving circuit in the circuit board 200 is driven, or the like.

The connection region CR may be a region positioned between the plurality of pixels PX and the connection pads PAD. An interconnection structure, such as a common electrode, electrically connected to the plurality of pixels PX may be disposed in the connection region CR.

An edge region ISO may be a region along edges of the pixel array 300. The frame 11 may be disposed around the pixel array 300, and may serve as a guide defining a space in which the pixel array 300 is disposed. The frame 11 may include, for example, at least one of materials such as polymer, ceramic, semiconductor, or metal.

FIG. 10 is a side cross-sectional view of a display device according to an example embodiment.

Referring to FIG. 10, the display device 1000 may include a circuit board 200, and a pixel array 300 disposed on the circuit board 200.

The circuit board 200 may include a semiconductor substrate 201, a driving circuit including driving elements 220 formed on the semiconductor substrate 201, interconnectors 230 electrically connected to the driving elements 220, interconnection lines 240 on the interconnectors 230, and a first interconnection insulating layer 290 covering the driving circuit. The circuit board 200 may further include a first bonding insulating layer 295 on the first interconnection insulating layer 290, and first bonding electrodes 298 disposed in the first bonding insulating layer 295, the first bonding electrodes 298 connected to the interconnection lines 240.

The semiconductor substrate 201 may include impurity regions including source/drain regions 205. The semiconductor substrate 201 may include, for example, a semiconductor such as silicon (Si) or germanium (Ge), or a compound semiconductor such as SiGe, SiC, GaAs, InAs, or InP.

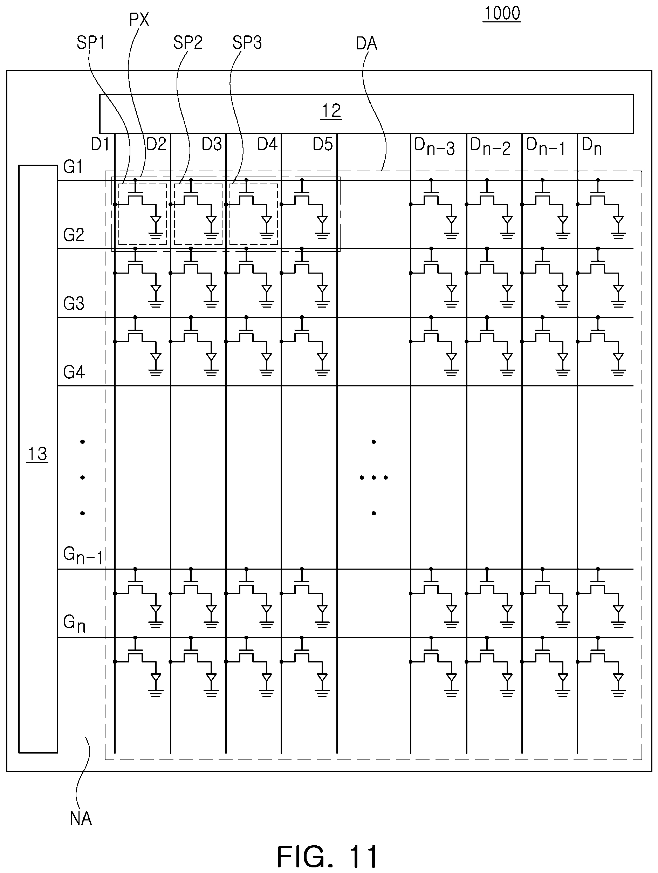

The driving circuit may include a circuit for controlling driving of a pixel, particularly a subpixel. The source region 205 of the driving elements 220 may be electrically connected to electrodes on one sides of the light emitting stacks 40 through the interconnector 230, the interconnection line 240, and the first bonding electrode 298. For example, the drain region 205 of the driving elements 220 may be connected to data lines D1, D2, ..., and Dn through the interconnector 230 and the interconnection line 240. The gate electrodes 221 of the driving elements 220 may be connected to gate lines G1, G2, ..., and Gn through the interconnector 230 and the interconnection line 240. Components and operations of the circuit will be described in more detail with reference to FIG. 11 below.

Upper surfaces of the first bonding electrodes 298 and upper surfaces of the first bonding insulating layer 295 may form an upper surface of the circuit board 200. The first bonding electrodes 298 may be bonded to second bonding electrodes 198 of the pixel array 300 to provide an electrical connection path. The first bonding electrodes 298 may include a conductive material, for example, copper (Cu). The first bonding insulating layer 295 may be bonded to the second bonding insulating layer 195 of the pixel array 300. The first bonding insulating layer 295 may include, for example, at least one of SiO, SiN, SiCN, SiOC, SiON, and SiOCN.

The pixel array 300 may include a plurality of light emitting elements 100 arranged for each of subpixels SP1, SP2, and SP3. A light emitting element 100 may use the light emitting element 100 according to the example embodiments described with reference to FIGS. 1 to 7. For example, a size D of the light emitting element 100 may be 200 µm or less. For application to mobile devices such as AR and VR, the size of the light emitting element 100 may be preferably 20 µm or less. A distance between adjacent light emitting elements 100 may be 5 nm to 100 µm, more preferably 5 nm to 20 µm. At least some first electrodes 82 and/or second electrodes 84, among first electrodes 82 and second electrodes 84 of a plurality of light emitting elements (devices) 100, may form to have a single body.

The pixel array 300 may include a plurality of light emitting stacks 40, a passivation layer 120 covering a side surface of each of the light emitting stacks 40, and first and second electrodes 82 and 84 electrically connected to the plurality of light emitting stacks 40. The pixel array 300 may include wavelength converters 160R, 160G, and 160B on the light emitting stacks 40, color filters 180R and 180G, and microlenses 185. The pixel array 300 may further include a partition structure BS surrounding side surfaces of the wavelength converters 160R, 160G, and 160B, the partition structure BS separating the wavelength converters from each other. In addition, the pixel array 300 may further include an encapsulation layer 182 and a planarization layer 184 on the wavelength converters 160R, 160G, and 160B, a common electrode 145, a first pad electrode 147, a second interconnection insulating layer 190, and a second bonding insulating layer 195, second bonding electrodes 198, and a second pad electrode 199.

The light emitting stacks 40 include P-type nitride semiconductor layers 70, N-type nitride semiconductor layers 50, and active layers 60 disposed therebetween. The first electrode 82 may be electrically connected to the N-type nitride semiconductor layer 50, and the second electrodes 84 may be electrically connected to the P-type nitride semiconductor layer 70. The passivation layer 120 may extend to lower surfaces of the light emitting stacks 40, and the second electrodes 84 may pass through the passivation layer 120 to be connected to the P-type nitride semiconductor layers 70.

The pixel array 300 may further include P-type contact electrodes 85 in contact with the entire lower surface of each of the P-type nitride semiconductor layers 70. In this case, the passivation layer 120 may cover the P-type contact electrodes 85 and extend to the lower surfaces of the light emitting stacks 40. The second electrodes 84 may be in contact with the P-type contact electrodes 85. The P-type contact electrodes 85 may have a central portion thicker than a peripheral portion thereof.

The wavelength converters 160R, 160G, and 160B may be disposed on the light emitting stacks 40, respectively. The wavelength converters 160R, 160G, and 160B may be regions in which a wavelength conversion material, such as a quantum dot, is filled and cured in the partition structure BS in a state of being dispersed in a liquid binder resin. A first wavelength converter 160R and a second wavelength converter 160G may include quantum dots capable of converting blue light into red light and green light, respectively, and a third wavelength converter 160B may include only a binder resin, without a quantum dot, to form a transparent resin portion.

Partition reflective layers 170 may be disposed in the partition structure BS to surround the side surfaces and lower surfaces of the wavelength converters 160R, 160G, and 160B. The partition reflective layers 170 may respectively include a first partition insulating layer 172, a partition metal layer 174, and a second partition insulating layer 176, disposed sequentially from the bottom. The partition metal layer 174 may be disposed only on the side surfaces of the wavelength converters 160R, 160G, and 160B, and may not be disposed below the lower surfaces. The lower surfaces of the partition reflective layers 170 may be positioned on a level higher than that of an uppermost surface of the first electrode 82. The first partition insulating layer 172 and the second partition insulating layer 176 may include an insulating material, for example, at least one of SiO₂, SiN, SiCN, SiOC, SiON, and SiOCN. The partition metal layer 174 may include a reflective metal, for example, at least one of silver (Ag), nickel (Ni), and aluminum (Al).

The encapsulation layer 182 may be disposed to cover the upper surfaces of the wavelength converters 160R, 160G, and 160B. The encapsulation layer 182 may function as a protective layer preventing a degradation in the wavelength converters 160R, 160G, and 160B. In some example embodiments, the encapsulation layer 182 may be omitted.

In the second and third subpixels SP2 and SP3, the color filters 180R and 180G may be disposed on the wavelength converter 160R, 160G, and 160B. The color filters 180R and 180G may increase the color purity of light emitted through the first wavelength converter 160R and the second wavelength converter 160G. In some example embodiments, a color filter may be further disposed on the third wavelength converter 160B.

A planarization layer 184 may be disposed to cover upper surfaces of the color filters 180R and 180G and the encapsulation layer 182. The planarization layer 184 may be a transparent layer.

The microlenses 185 may be disposed to respectively correspond to the wavelength converters 160R, 160G, and 160B, on the planarization layer 184. The microlenses 185 may converge light incident from the wavelength converters 160R, 160G, and 160B. For example, the microlenses 185 may have a diameter greater than a width W1 of each of the light emitting stacks 40 in an X-direction and a Y-direction. The microlenses 185 may be formed of, for example, a transparent photoresist material or a transparent thermosetting resin film.

The light emitting stack 40 may be formed by performing deposition on a growth substrate 10, using a method such as metal organic chemical vapor deposition (MOCVD). When the growth substrate 10, formed of a material different from that of the light emitting stack, is used, a buffer stack 20 may be formed on the growth substrate 10, and then the light emitting stack 40 may be formed on the buffer stack 20. The light emitting stack 40 may be formed of a nitride semiconductor including Ga.

The growth substrate 10 and the buffer stack 20 may be partially or entirely removed during a process of manufacturing the light emitting element 100. Accordingly, the light emitting element 100 may further include the growth substrate 10, and may further include the buffer stack 20 between the growth substrate 10 and the light emitting stack 40. In some cases, only a portion of the buffer stack 20 may be further included without the growth substrate 10.

In order to form the pixel array 300, in the same manner as a method of manufacturing the light emitting element 100 in FIG. 1, the buffer stack 20 may be formed on the growth substrate 10, the light emitting stack 40 may be formed by sequentially stacking the N-type nitride semiconductor layer 50, the active layer 60, and the P-type nitride semiconductor layer 70 on the buffer stack 20, and then a light emitting stack 40 of an element isolation region DS may be removed in a direction of the P-type nitride semiconductor layer 70, thereby forming the plurality of light emitting stacks 40. In addition, the growth substrate 10 and the buffer stack 20 may be partially or entirely removed from a direction of a substrate. In an example embodiment, in window regions respectively corresponding to the light emitting stacks 40, grooves for disposing the wavelength converters 160R, 160G, and 160B may be formed by an etching process. In this process, a partition structure BS may be formed on the element isolation region DS. In the window regions in which the wavelength converters 160R, 160G, and 160B are to be installed, the entire substrate may be removed, and the buffer stack 20 may be partially or entirely removed. in some example embodiments, the growth substrate 10 and the buffer stack 20 may be partially or entirely removed at a portion corresponding to the partition on the element isolation region DS. In one example, when the growth substrate 10 is not entirely removed, the partition structure BS of the pixel array 300 may include the growth substrate 10, and may further include a portion of the buffer stack 20. In another example, when the growth substrate 10 is entirely removed, the partition structure BS of the pixel array 300 may include a portion of the buffer stack 20 or the light emitting stack 40.

FIG. 11 is a driving circuit implemented by a display device according to an example embodiment.

Referring to FIG. 11, a circuit diagram of a display device 1000 in which n×n subpixels are arranged is illustrated. First to third subpixels SP1, SP2, and SP3 may each receive a data signal through data lines D1 to Dn, paths in a vertical direction, for example, paths in a column direction. The first to third subpixels SP1, SP2, and SP3 may receive a control signal, that is, a gate signal, through gate lines G1 to Gn, paths in a horizontal direction, for example, paths in a row direction.

A plurality of pixels PX, including the first to third subpixels SP1, SP2, and SP3, may provide an active region DA for display, and the active region DA may be provided as a display region for a user. A non-active region NA may be formed along one or more edges of the active region DA. The non-active region NA may be a region extending along an outer periphery of a panel of the display device 1000, the region in which pixels PX are not present, and may correspond to a frame 11 of the display device 1000 (see FIG. 8).

First and second driver circuits 12 and 13 may be applied to control the operation of the pixels PX, that is, the first to third subpixels SP1, SP2, and SP3. A portion or all of the first and second driver circuits 12 and 13 may be implemented on a circuit board 200. The first and second driver circuits 12 and 13 may be formed as integrated circuits, thin film transistor panel circuits, or other suitable circuits, and may be disposed in the non-active region NA of the display device 1000. The first and second driver circuits 12 and 13 may include a microprocessor, a memory such as a storage, a processing circuit, and a communication circuit.

In order to display an image by the pixels PX, the first driver circuit 12 may transmit a clock signal and other control signals to the second driver circuit 13, a gate driver circuit, while supplying image data to the data lines D1 to Dn. The second driver circuit 13 may be implemented using an integrated circuit and/or a thin film transistor circuit. A gate signal for controlling the first to third subpixels SP1, SP2, and SP3, arranged in the row direction, may be transmitted through the gate lines G1 to Gn of the display device 1000.

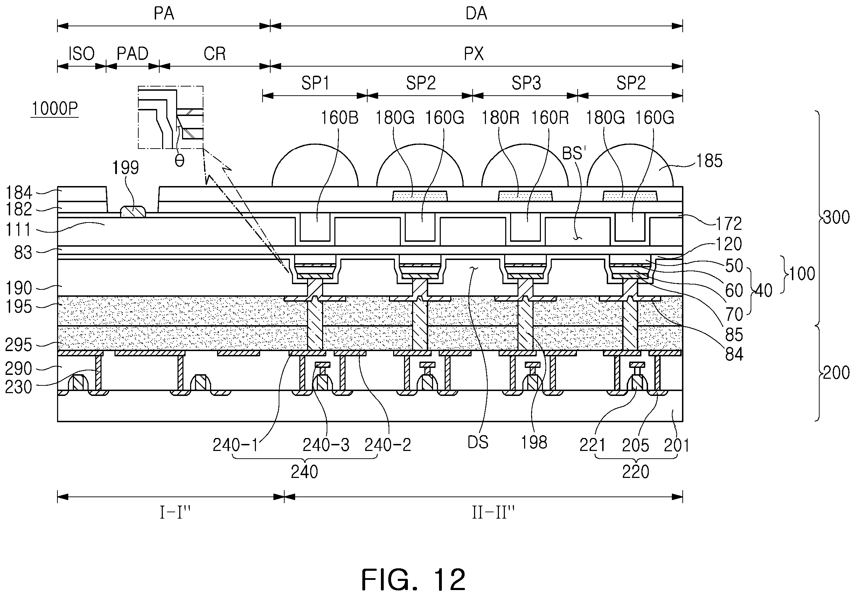

FIG. 12 is a side cross-sectional view of a display device according to an example embodiment.

Referring to FIG. 12, a display device 1000A according to an example embodiment may include a circuit board 200, and a pixel array 300 disposed on the circuit board 200, and may include components the same as most components of the display device 1000 described with reference to FIG. 10. However, the display device 1000A may have a partition structure BS' and an interconnection structure, different from the partition structure BS and the interconnection structure described above.

The pixel array 300 may include a partition structure BS', formed separately from light emitting stacks 40. The partition structure BS' may include a conductive material. The partition structure BS' may act as a portion of a first electrode structure. In this case, the partition structure BS' may be disposed between respective light emitting stacks 40 to overlap a portion of a peripheral region of the light emitting stack 40 in a Z-axis direction.

The partition structure BS' may be connected to an N-type nitride semiconductor layer 50 of each of the light emitting stacks 40 through an N-type contact electrode 83. The N-type contact electrode 83 may be formed of a transparent conductive material such as ITO. The N-type contact electrode 83 may also be in direct contact with the N-type nitride semiconductor layer 50 without an N-type contact electrode. The partition structure BS may be formed of a material having high reflectivity, such as Ag, and the first partition insulating layer 172, surrounding side surfaces of wavelength converters 160R, 160G, and 160B, may be disposed on the partition structure BS. The pixel array 300 may include a second pad electrode 199, formed on an exposed region of the partition structure BS.

The display devices 1000 and 1000A according to the example embodiments of FIGS. 8, 9, and 10 may be full-color monolithic display devices including a light emitting element array, formed on a wafer level. The display devices 1000 and 1000A may have a feature of increasing density between light emitting elements by forming the light emitting element array on the wafer level without a pick-and-place process of an individual chip of an individual light emitting element 100. A width of an element isolation region for isolating light emitting elements from each other on a wafer may be a distance between light emitting elements of the display devices 1000 and 1000A.

A display device according to example embodiments is not limited to the display devices 1000 and 1000A, and some components may be excluded or modified. For example, a single-color monolithic display device may be configured, excluding wavelength converters 160B, 160G, and 160R or color filters 180R and 180G. The display device 1000 may be formed by moving a light emitting element 100 on a circuit board using a pick-and-place method. The light emitting elements 100, 100A, 100B, and 100C according to the example embodiments of FIGS. 1 to 7 may be arranged in an array form, and may be combined with a substrate including a driving element to form the display device 1000 according to an example embodiment.

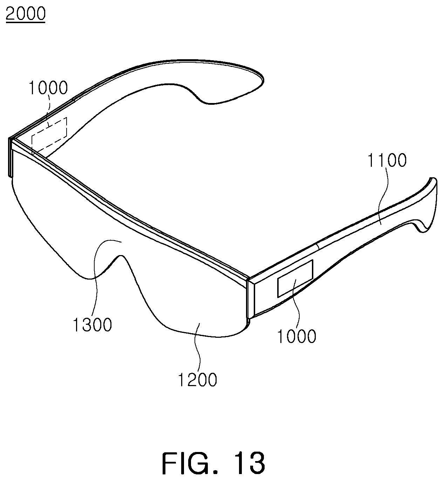

FIG. 13 is a schematic diagram illustrating an electronic device including a display device according to an example embodiment.

Referring to FIG. 13, an electronic device 2000 may be a glasses-type display, a wearable device. The electronic device 2000 may include a pair of temples 1100, a pair of optical coupling lenses 1200, and a bridge 1300. The electronic device 2000 may further include a display device 1000 including an image generator.

The electronic device 2000 may be a head-mounted, glasses-type, or goggle-type virtual reality (VR) device, an augmented reality (AR) device, or a mixed reality (MR) device capable of providing virtual reality, or providing a virtual image and external real-world scenery together.

The temples 1100 may extend in one direction. The temples 1100 may be spaced apart from each other and may extend to be parallel to each other. The temples 1100 may be folded toward the bridge 1300. The bridge 1300 may be provided between the optical coupling lenses 1200 to connect the optical coupling lenses 1200 to each other. The optical coupling lenses 1200 may include a light guide plate. The display device 1000 may be disposed on each of the temples 1100, and may generate images on the optical coupling lenses 1200. The display device 1000 may be a display device according to the example embodiments described above with reference to FIGS. 1 to 11.

One or more example embodiments provide an ultra-small LED element having excellent reliability and high luminous efficiency, and a display device (1000) using the same.

## Claims

1. A light emitting element (100) comprising:
a light emitting stack (40) comprising an active layer (60) between an N-type nitride semiconductor layer (50) and a P-type nitride semiconductor layer (70), the light emitting stack (40) having a width of 5 nm or more and 200 µm or less;
a first electrode (82) connected to the N-type nitride semiconductor layer (50); and
a second electrode (84) connected to the P-type nitride semiconductor layer (70),
wherein the P-type nitride semiconductor layer (70) has a first surface (70n), adjacent to the active layer (60), and a second surface (70f), opposite to the first surface (70n), and comprises AlₓIn_{y}Ga_{z}N, wherein 0 ≤ x < 1, 0 ≤ y < 1 and 0 < z ≤ 1,
wherein the N-type nitride semiconductor layer (50) comprises an electron retardation layer (53),
**characterised in that**
a bandgap of the p-type nitride semiconductor layer (70) does not increase in a stacking direction from the second surface (70f) to the first surface (70n), and **in that**
the N-type nitride semiconductor layer further comprises a superlattice layer (52).

2. The light emitting element (100) of claim 1, wherein the N-type nitride semiconductor layer (50) further comprises an N-type highly doped layer having an N-type impurity concentration higher than that of a remaining region of the N-type nitride semiconductor layer (50), and the superlattice layer (52) and the electron retardation layer (53) are between the N-type highly doped layer and the active layer (60).

3. The light emitting element (100) of claim 1 or 2, wherein a distance (G_{SA}) between the superlattice layer (52) and the active layer (60) is 0.5 nm or more and 1000 nm or less.

4. The light emitting element (100) of any one of claims 1 to 3, wherein a distance (G_{RA}) between the electron retardation layer (53) and the active layer (60) is 0.5 nm or more and 1000 nm or less.

5. The light emitting element (100) of any one of claims 1 to 4, wherein the superlattice layer (52) is between the electron retardation layer (53) and the active layer (60), and
wherein a distance (G_{RS}) between the superlattice layer (52) and the electron retardation layer (53) is 0.5 nm to 5000 nm.

6. The light emitting element (100) of any one of claims 1 to 5, wherein a thickness of the electron retardation layer (53) is 2 nm or more and 1000 nm or less.

7. The light emitting element (100) of any one of claims 1 to 6, wherein the electron retardation layer (53) comprises Alₓ₅In_{y5}Ga_{z5}N, wherein 0 < x5 < 1, 0 ≤ y5 < 1, 0 < z5 < 1.

8. The light emitting element (100) of any one of claims 1 to 7, wherein the electron retardation layer (53) comprises first sublayers (53a) and second sublayers (53b) that are alternately provided, each having a thickness of 0.1 nm to 1000 nm, and
wherein the first sublayers (53a) comprise Alₓ₃In_{y3}Ga_{z3}N, wherein 0 < x3 < 1, 0 ≤ y3 < 1 and 0 < z3 < 1, and
wherein the second sublayers (53b) comprise Alₓ₄In_{y4}Ga_{z4}N, wherein 0 ≤ x4 < 1, 0 ≤ y4 < 1 and 0 < z4 ≤ 1.

9. The light emitting element (100) of any one of claims 1 to 8, wherein an Al composition ratio (x) in the P-type nitride semiconductor layer (70) is constant in a constant section of the P-type nitride semiconductor layer (70), and the Al composition ratio (x) is 0 or more and 0.5 or less.

10. The light emitting element (100) of any one of claims 1 to 9, wherein an Al composition ratio (x) in the P-type nitride semiconductor layer (70) decreases from the second surface (70f) to the first surface (70n), and the Al composition ratio (x) is 0 or more and 0.5 or less.

11. The light emitting element (100) of claim 10, wherein the Al composition ratio (x) in the P-type nitride semiconductor layer (70) decreases linearly or gradually from the second surface (70f) to the first surface (70n).

12. The light emitting element (100) of claim 10, wherein the Al composition ratio (x) in the P-type nitride semiconductor layer (70) decreases in a stepwise manner from the second surface (70f) to the first surface (70n).

13. The light emitting element (100) of any one of claims 10 to 12, wherein the Al composition ratio (x) in the P-type nitride semiconductor layer (70) is constant from the first surface (70n) to a level between the first surface (70n) and the second surface (70f), and decreases from the level to the second surface (70f).

14. The light emitting element (100) of any one of claims 1 to 13, wherein the P-type nitride semiconductor layer (70) has a first width adjacent to the first surface (70n) and a second width adjacent to the second surface (70f), and
wherein the first width is greater than the second width.

15. A display device (1000) comprising:
a circuit board (200) comprising a plurality of driving circuits; and
a pixel array (300) comprising a plurality of light emitting elements (100), which comprises a light emitting element (100) of any one of claims 1 to 14, on the circuit board (200).

## Patentansprüche

1. Ein lichtemittierendes Element (100), umfassend:
einen lichtemittierenden Stapel (40), welcher eine aktive Schicht (60) zwischen einer N-Typ-Nitrid-Halbleiterschicht (50) und einer P-Typ-Nitrid-Halbleiterschicht (70) umfasst, wobei der lichtemittierende Stapel (40) eine Breite von 5 nm oder mehr und 200 µm oder weniger aufweist;
eine erste Elektrode (82), die mit der N-Typ-Nitrid-Halbleiterschicht (50) verbunden ist; und
eine zweite Elektrode (84), die mit der P-Typ-Nitrid-Halbleiterschicht (70) verbunden ist,
wobei die P-Typ-Nitrid-Halbleiterschicht (70) eine erste Oberfläche (70n), die an die aktive Schicht (60) angrenzt, und eine zweite Oberfläche (70f) aufweist, die der ersten Oberfläche (70n) gegenüberliegt, und AlₓIn_{y}Ga_{z}N umfasst, wobei 0 ≤ x < 1, 0 ≤ y < 1 und 0 < z ≤ 1,
wobei die N-Typ-Nitrid-Halbleiterschicht (50) eine Elektronenverzögerungsschicht (53) umfasst, **dadurch gekennzeichnet, dass**
eine Bandlücke der p-Typ-Nitrid-Halbleiterschicht (70) in einer Stapelrichtung von der zweiten Oberfläche (70f) zur ersten Oberfläche (70n) nicht zunimmt, und dass
die N-Typ-Nitrid-Halbleiterschicht ferner eine Supergitterschicht (52) umfasst.

2. Das lichtemittierende Element (100) nach Anspruch 1, wobei die N-Typ-Nitrid-Halbleiterschicht (50) ferner eine hochdotierte N-Typ-Schicht mit einer N-Typ-Verunreinigungskonzentration umfasst, die höher ist als die eines verbleibenden Bereichs der N-Typ-Nitrid-Halbleiterschicht (50), und die Übergitterschicht (52) und die Elektronenverzögerungsschicht (53) sich zwischen der hochdotierten N-Typ-Schicht und der aktiven Schicht (60) befinden.

3. Das lichtemittierende Element (100) nach Anspruch 1 oder 2, wobei ein Abstand (G_{SA}) zwischen der Übergitterschicht (52) und der aktiven Schicht (60) 0,5 nm oder mehr und 1000 nm oder weniger beträgt.

4. Das lichtemittierende Element (100) nach einem der Ansprüche 1 bis 3, wobei ein Abstand (G_{RA}) zwischen der Elektronenverzögerungsschicht (53) und der aktiven Schicht(60) 0,5 nm oder mehr und 1000 nm oder weniger beträgt.

5. Das lichtemittierende Element (100) nach einem der Ansprüche 1 bis 4, wobei sich die Übergitterschicht (52) zwischen der Elektronenverzögerungsschicht (53) und der aktiven Schicht (60) befindet, und
wobei ein Abstand (G_{RS}) zwischen der Übergitterschicht (52) und der Elektronenverzögerungsschicht (53) 0,5 nm bis 5000 nm beträgt.

6. Das lichtemittierende Element (100) nach einem der Ansprüche 1 bis 5, wobei die Dicke der Elektronenverzögerungsschicht (53) 2 nm oder mehr und 1000 nm oder weniger beträgt.

7. Das lichtemittierende Element (100) nach einem der Ansprüche 1 bis 6, wobei die Elektronenverzögerungsschicht (53) Alₓ₅In_{y5}Ga_{z5}N umfasst, wobei 0 < x5 < 1, 0 ≤ y5 < 1, 0 < z5 < 1.

8. Das lichtemittierende Element (100) nach einem der Ansprüche 1 bis 7, wobei
die Elektronenverzögerungsschicht (53) erste Unterschichten (53a) und zweite Unterschichten (53b) umfasst, welche abwechselnd angeordnet sind und jeweils eine Dicke von 0,1 nm bis 1000 nm aufweisen, und
wobei die ersten Unterschichten (53a) Alₓ₃In_{y3}Ga_{z3}N umfassen, wobei 0 < x3 < 1, 0 ≤ 3 < 1 und 0 < z3 < 1, und
wobei die zweiten Unterschichten (53b) Alₓ₄In_{y4}Ga_{z4}N umfassen, wobei 0 ≤ x4 < 1, 0 ≤ y4 < 1 und 0 < z4 ≤ 1.

9. Das lichtemittierende Element (100) nach einem der Ansprüche 1 bis 8, wobei ein Al-Zusammensetzungsanteil (x) in der P-Typ-Nitrid-Halbleiterschicht (70) in einem konstanten Abschnitt der P-Typ-Nitrid-Halbleiterschicht (70) konstant ist und der Al-Zusammensetzungsanteil (x) 0 oder mehr und 0,5 oder weniger beträgt.

10. Das lichtemittierende Element (100) nach einem der Ansprüche 1 bis 9, wobei ein Al-Zusammensetzungsanteil (x) in der P-Typ-Nitrid-Halbleiterschicht (70) von der zweiten Oberfläche (70f) zur ersten Oberfläche (70n) abnimmt und der Al-Zusammensetzungsanteil (x) 0 oder mehr und 0,5 oder weniger beträgt.

11. Das lichtemittierende Element (100) nach Anspruch 10, wobei der Al-Zusammensetzungsanteil (x) in der P-Typ-Nitrid-Halbleiterschicht (70) linear oder allmählich von der zweiten Oberfläche (70f) zur ersten Oberfläche (70n) abnimmt.

12. Das lichtemittierende Element (100) nach Anspruch 10, wobei der Al-Zusammensetzungsanteil (x) in der P-Typ-Nitrid-Halbleiterschicht (70) von der zweiten Oberfläche (70f) zur ersten Oberfläche (70n) stufenweise abnimmt.

13. Das lichtemittierende Element (100) nach einem der Ansprüche 10 bis 12, wobei der Al-Zusammensetzungsanteil (x) in der P-Typ-Nitrid-Halbleiterschicht (70) von der ersten Oberfläche (70n) bis zu einem Niveau zwischen der ersten Oberfläche (70n) und der zweiten Oberfläche (70f) konstant ist und von diesem Niveau bis zur zweiten Oberfläche (70f) abnimmt.

14. Das lichtemittierende Element (100) nach einem der Ansprüche 1 bis 13, wobei die P-Typ-Nitrid-Halbleiterschicht (70) eine erste Breite benachbart zur ersten Oberfläche (70n) und eine zweite Breite benachbart zur zweiten Oberfläche (70f) aufweist, und
wobei die erste Breite größer ist als die zweite Breite.

15. Eine Anzeigevorrichtung (1000), umfassend:
eine Leiterplatte (200), die eine Mehrzahl von Ansteuerschaltungen umfasst; und
eine Pixelanordnung (300), die eine Mehrzahl von lichtemittierenden Elementen (100) umfasst, die ein lichtemittierendes Element (100) nach einem der Ansprüche 1 bis 14 auf der Leiterplatte (200) umfasst.

## Revendications

1. Un élément émetteur de lumière (100) comprenant :
une pile émettrice de lumière (40) comprenant une couche active (60) entre une couche semi-conductrice en nitrure de type N (50) et une couche semi-conductrice en nitrure de type P (70), la pile émettrice de lumière (40) ayant une largeur de 5 nm ou plus et de 200 µm ou moins ;
une première électrode (82) connectée à la couche semi-conductrice en nitrure de type N (50) ; et
une deuxième électrode (84) connectée à la couche semi-conductrice en nitrure de type P (70),
dans lequel la couche semi-conductrice en nitrure de type P (70) a une première surface (70n), adjacente à la couche active (60), et une deuxième surface (70f), opposée à la première surface (70n), et comprend AlₓIn_{y}Ga_{z}N, où 0 ≤ x < 1, 0 ≤ y < 1 et 0 < z ≤ 1,
où la couche semi-conductrice en nitrure de type N (50) comprend une couche de retardement des électrons (53), **caractérisé en ce que**
une bande interdite de la couche semi-conductrice en nitrure de type P (70) n'augmente pas dans une direction d'empilement depuis la deuxième surface (70f) vers la première surface (70n), et **en ce que**
la couche semi-conductrice en nitrure de type N comprend en outre une couche de super-réseau (52).

2. L'élément émetteur de lumière (100) selon la revendication 1, dans lequel la couche semi-conductrice en nitrure de type N (50) comprend en outre une couche fortement dopée de type N ayant une concentration en impuretés de type N supérieure à celle d'une région restante de la couche semi-conductrice en nitrure de type N (50), et la couche de super-réseau (52) et la couche de retardement d'électrons (53) se trouvent entre la couche fortement dopée de type N et la couche active (60).

3. L'élément émetteur de lumière (100) selon la revendication 1 ou 2, dans lequel une distance (G_{SA}) entre la couche de super-réseau (52) et la couche active (60) est 0,5 nm ou plus et 1000 nm ou moins.

4. L'élément émetteur de lumière (100) selon l'une des revendications 1 à 3, dans lequel une distance (G_{RA}) entre la couche de retardement des électrons (53) et la couche active (60) est 0,5 nm ou plus et 1000 nm ou moins.

5. L'élément émetteur de lumière (100) selon l'une des revendications 1 à 4, dans lequel la couche de super-réseau (52) est située entre la couche de retardement des électrons (53) et la couche active (60), et
dans lequel la distance (G_{RS}) entre la couche de super-réseau (52) et la couche de retardement des électrons (53) est de 0,5 nm à 5000 nm.

6. L'élément émetteur de lumière (100) selon l'une des revendications 1 à 5, dans lequel l'épaisseur de la couche de retardement des électrons (53) est 2 nm ou plus et 1000 nm ou moins.

7. L'élément émetteur de lumière (100) selon l'une des revendications 1 à 6, dans lequel la couche de retardement des électrons (53) comprend Alₓ₅In_{y5}Ga_{z5}N, où 0 < x5 < 1, 0 ≤ y5 < 1, 0 < z5 < 1.

8. L'élément émetteur de lumière (100) selon l'une des revendications 1 à 7, dans lequel la couche de retardement des électrons (53) comprend des premières sous-couches (53a) et des deuxièmes sous-couches (53b) qui sont disposées en alternance, chacune ayant une épaisseur de 0,1 nm à 1000 nm, et
dans lequel les premières sous-couches (53a) comprennent Alₓ₃In_{y3}Ga_{z3}N, où 0 < x3 < 1, 0 ≤ y3 < 1 et 0 < z3 < 1, et
dans lequel les deuxièmes sous-couches (53b) comprennent Alₓ₄In_{y4}Ga_{z4}N, où 0 ≤ x4 < 1, 0 ≤ y4 < 1 et 0 < z4 ≤ 1.

9. L'élément émetteur de lumière (100) selon l'une des revendications 1 à 8, dans lequel un rapport de composition en Al (x) dans la couche semi-conductrice en nitrure de type P (70) est constant dans une section constante de la couche semi-conductrice en nitrure de type P (70), et le rapport de composition en Al (x) est supérieur ou égal à 0 et inférieur ou égal à 0,5.

10. L'élément émetteur de lumière (100) selon l'une des revendications 1 à 9, dans lequel un rapport de composition en Al (x) dans la couche semi-conductrice en nitrure de type P (70) diminue de la deuxième surface (70f) vers la première surface (70n), et le rapport de composition en Al (x) est supérieur ou égal à 0 et inférieur ou égal à 0,5.

11. L'élément émetteur de lumière (100) selon la revendication 10, dans lequel le rapport de composition en Al (x) dans la couche semi-conductrice en nitrure de type P (70) diminue de manière linéaire ou progressive depuis la deuxième surface (70f) vers la première surface (70n).

12. L'élément émetteur de lumière (100) selon la revendication 10, dans lequel le rapport de composition en Al (x) dans la couche semi-conductrice en nitrure de type P (70) diminue de manière progressive depuis la deuxième surface (70f) vers la première surface (70n).

13. L'élément émetteur de lumière (100) selon l'une des revendications 10 à 12, dans lequel le rapport de composition en Al (x) dans la couche semi-conductrice en nitrure de type P (70) est constant depuis la première surface (70n) jusqu'à un niveau situé entre la première surface (70n) et la deuxième surface (70f), et diminue depuis ce niveau jusqu'à la deuxième surface (70f).

14. L'élément émetteur de lumière (100) selon l'une des revendications 1 à 13, dans lequel la couche semi-conductrice en nitrure de type P (70) présente une première largeur adjacente à la première surface (70n) et une deuxième largeur adjacente à la deuxième surface (70f), et
dans lequel la première largeur est supérieure à la deuxième largeur

15. Un dispositif d'affichage (1000) comprenant :
un circuit imprimé (200) comprenant une pluralité de circuits de commande ; et
un réseau de pixels (300) comprenant une pluralité d'éléments émetteurs de lumière (100), qui comprend un élément émetteur de lumière (100) de l'une des revendications 1 à 14, sur le circuit imprimé (200).
